# EUROPÄISCHE PATENTANMELDUNG

(11) **EP 4 484 848 A1**
(43) Veröffentlichungstag der Anmeldung: **01.01.2025**
(21) Anmeldenummer: 23181926.9
(22) Anmeldetag: 27.06.2023
(51) Int. Cl.: F24H 7/04, F28D 20/00

(54) **WÄRMESPEICHER MIT WÄRMESPEICHERKASSETTEN**

(71) Anmelder: Lumenion GmbH, 10829 Berlin (DE)
(72) Erfinder: Kordt, Peter, 10829 Berlin (DE); Kuschminder, Eric, 10829 Berlin (DE); JOLLY, Param Preet Singh, 10829 Berlin (DE); Falla Peña, Santiago, 10829 Berlin (DE)
(74) Vertreter: Ridderbusch, Oliver

(57) **Zusammenfassung**

Ein Wärmespeicher zum Speichern elektrischer Energie in Form von Wärmeenergie umfasst mindestens eine elektrische Heizvorrichtung (40) zum Umwandeln von elektrischer Energie in Wärmeenergie sowie mehrere Wärmespeicherkassetten (10). Jede Wärmespeicherkassette (10) umfasst einen Kassettenrahmen (20) und mehrere im Kassettenrahmen (20) gehaltene Wärmespeicherstangen (30). Jede Wärmespeicherkassette (10) umfasst Halterungen (22) zum Halten der Wärmespeicherstangen (30) in einer vorgegebenen Position, wobei mindestens ein Ende (31) jeder Wärmespeicherstange (30) unfixiert ist, so dass innerhalb des Kassettenrahmens (20) eine freie thermische Expansion der Wärmespeicherstangen (30) in Längsrichtung (L) der Wärmespeicherstangen (30) ermöglicht ist.

## Beschreibung

### TECHNISCHES GEBIET

Die vorliegende Offenbarung bezieht sich auf einen Wärmespeicher zum Speichern elektrischer Energie in Form von Wärmeenergie und ein Verfahren zur Herstellung eines Wärmespeichers.

### HINTERGRUND

Im Rahmen einer effizienten Energiegewinnung und -nutzung kommt der vorübergehenden Speicherung von Energie eine zunehmend wichtige Rolle zu. Elektrische Energie wird in steigendem Umfang durch Wind- und Photovoltaikanlagen erzeugt, wobei insbesondere wegen Schwankungen der erzeugten und/oder momentan benötigten Energiemenge eine Speicherung der elektrischen Energie ermöglicht werden soll. Hierzu werden einerseits elektrochemische Speicher verwendet, welche jedoch mit verhältnismäßig hohen Herstellungskosten verbunden sind. Verbreitet sind auch Pumpspeicherwerke, welche jedoch meist nur in geographisch geeigneten Gebieten eingesetzt werden und aus Umweltgründen umstritten sind. Eine weitere Möglichkeit der Energiespeicherung bieten Wärmespeicher, in denen elektrische Energie in Wärmeenergie umgewandelt und gespeichert wird. Aus dem Wärmespeicher entnommene Wärmeenergie kann zur Elektrizitätserzeugung und/oder Wärmeversorgung genutzt werden.

Zur Wärmespeicherung werden verschiedene Materialien eingesetzt, wobei Hochtemperaturwärmespeicher, welche Metalle (z.B. Stahl) zur Wärmespeicherung nutzen, relevante Vorteile bieten: Metalle erlauben eine Energiespeicherung durch verhältnismäßig hohe Temperaturen, wodurch ein Wirkungsgrad bei einer Elektrizitätserzeugung durch entnommene Wärmeenergie steigt. Außerdem können durch Metalle die Abmessungen des Wärmespeichers vergleichsweise kompakt sein, was insbesondere in urbanen Standorten relevant ist. Weiterhin erlauben Wärmespeicher mit Metallkörpern zur Wärmespeicherung eine zumindest teilweise Montage von Modulen des Wärmespeichers, bevor ein Transport zum Einsatzort erfolgt. Dies kann Vorteile im Zusammenbau und den Herstellungskosten bieten.

Wärmespeicher mit einer elektrischen Heizvorrichtung und Metallkörpern zur Wärmespeicherung, insbesondere Metallstangen, wurden von der Anmelderin unter anderem in EP3708923B1, EP3647677B1, EP3633303B1, EP3655631B1 und EP4033191A1 beschrieben. Metallstangen bieten im Vergleich zu anderen Formen eine große Oberfläche und damit einen höheren Wärmetransfer. Gleichzeitig kommt der thermischen Ausdehnung bei einer Stangenform eine erhöhte Bedeutung zu, insbesondere wenn die verwendeten Metallstangen im Betrieb über mehrere Hundert Grad Celsius erhitzt werden. Durch beträchtliche Längenexpansionen und im Betrieb unvermeidbaren Temperaturdifferenzen innerhalb des Wärmespeichers stellen die mechanische Stabilität und die Vermeidung von Materialbelastungen wichtige Designaspekte dar. Zur Reduzierung von Materialspannungen hat die Anmelderin in EP3647677B1, EP3633303B1 und EP3655631B1 Designs entwickelt, welche thermische Ausdehnungen von Metallstangen weitgehend ermöglichen und Auswirkungen dieser Expansionen auf übrige Komponenten verringern.

Mit der vorliegenden Erfindung sollen über den gesamten Wärmespeicher hinweg Materialspannungen infolge thermischer Expansionen weitgehend vermieden werden, wobei zusätzlich die Herstellung möglichst einfach sein soll und der Gesamtaufbau eine hohe Stabilität bieten soll.

### KURZFASSUNG

Als eine **Aufgabe** der Erfindung kann angesehen werden, ein Wärmespeicher zum Speichern elektrischer Energie in Form von Wärmeenergie und ein Verfahren zur Herstellung eines Wärmespeichers anzugeben, welche eine hohe mechanische Stabilität bei einfacher Herstellungsweise ermöglichen sollen, ohne dass es durch thermische Expansionen zu übermäßigen Materialspannungen kommen kann.

Diese Aufgabe wird durch den Wärmespeicher und das Verfahren mit den Merkmalen der unabhängigen Ansprüche gelöst.

Ein erfindungsgemäßer Wärmespeicher zum Speichern elektrischer Energie in Form von Wärmeenergie umfasst mindestens eine elektrische Heizvorrichtung zum Umwandeln von elektrischer Energie in Wärmeenergie sowie mehrere Wärmespeicherkassetten. Jede Wärmespeicherkassette umfasst einen Kassettenrahmen und mehrere im Kassettenrahmen gehaltene Wärmespeicherstangen. Jede Wärmespeicherkassette umfasst Halterungen zum Halten der Wärmespeicherstangen in einer vorgegebenen Position, wobei mindestens ein Ende jeder Wärmespeicherstange unfixiert ist, so dass innerhalb des Kassettenrahmens eine freie thermische Expansion der Wärmespeicherstangen in Längsrichtung der Wärmespeicherstangen ermöglicht ist.

Optional kann ein Ende jeder Wärmespeicherstange auf einem Boden der Wärmespeicherkassette aufgestellt werden, sodass die Wärmespeicherstangen ihr Eigengewicht selbst tragen. Dadurch besteht kein zusätzlicher Bedarf an einzelnen an jeder Wärmespeicherstange befestigten oder mit ihr fest verbundenen Fixierungsstrukturen. Ein Kippschutz sowie eine sichere Positionierung der Wärmespeicherstangen wird hierbei durch die Halterungen erreicht, welche jeweils mit dem Kassettenrahmen verbunden sind und durch eine untere, mittlere und/oder obere Führungsschiene gebildet sein können, wie im Späteren näher beschrieben. In dieser Weise kann die nötige Komponentenanzahl sowie der Produktions- und Kostenaufwand zur Sicherstellung der Stabilität innerhalb des Systems immens reduziert werden. Die Führungsschienen können alle Wärmespeicherstangen einer Wärmespeicherkassette in Position halten, wobei die Anzahl gehaltener Wärmespeicherstangen eher gering sein kann (z.B. 5 bis 10 Wärmespeicherstangen) oder auch wesentlich höher sein kann (z.B. 15 bis 30 Wärmespeicherstangen).

Indem die Wärmespeicherstangen frei in Längsrichtung expandieren können, werden mechanische Spannungen innerhalb der Wärmespeicherstangen vermieden und Auswirkungen auf angrenzende Komponenten reduziert. Zur Minimierung von Materialspannungen an angrenzenden Komponenten kommt auch den Halterungen der Wärmespeicherkassette eine wichtige Rolle zu. Diese stützen oder halten lediglich Wärmespeicherstangen in einer bestimmten Position; indem auf starre Befestigungen wie z.B. durch ein Schweißen, Löten, Kleben, Verschrauben oder Vernieten zwischen den Halterungen und den Wärmespeicherstangen verzichtet wird, können eine Materialbeanspruchung und mechanische Spannungen an den Halterungen weitgehend vermieden werden. Gleichzeitig verbessern die Wärmespeicherkassetten die Gesamtstabilität und die Handhabung: Indem mehrere Wärmespeicherstangen in der Kassette zu einer stabilen Einheit zusammengefasst werden, wird die Montage am Einsatzort des Wärmespeichers erleichtert. Die Wärmespeicherkassetten an sich können bereits vorab zusammengebaut werden und als fertige Einheiten (insbesondere als Module, bestehend aus insbesondere einer höheren Anzahl von Kassetten, z.B. 6 bis 15 Kassetten) transportiert werden. Ein Umkippen oder ungewollte Bewegungen der Wärmespeicherstangen werden durch die Kassetten sowie deren Zusammenschluss in Form besagter Module sicher vermieden. Zudem bieten die Kassetten eine gewisse Entkopplung zwischen Wärmespeicherstangen und anderen Komponenten, so dass ein ungewollter Wärmetransfer auf übrige Komponenten und/oder Materialspannungen an übrigen Komponenten aufgrund von erhitzten Wärmespeicherstangen wesentlich reduziert werden. Der Wärmespeicher besitzt optional lediglich eine geringe Anzahl an nach außen ragenden Elementen, wobei einzig die elektrischen Kontakt-/ Anschlusspunkte (Kontaktstellen der Sensorik zur Verbindung zur SPS oder anderen Komponenten, benötigte Verkabelung der Mess- und Regelungstechnik im Allgemeinen) sowie die Kühlstrecken der Heizelemente nach außen hin Schnittstellen aufweisen. Damit können Wärmebrücken effizient vermieden werden, wodurch der Wärmeverlust minimiert wird und die Gesamteffizienz der Anlage, respektive des Anlagensystems gesteigert ist.

Bei einem erfindungsgemäßen Verfahren zur Herstellung eines Wärmespeichers zum Speichern elektrischer Energie in Form von Wärmeenergie wird mindestens eine elektrische Heizvorrichtung zum Umwandeln von elektrischer Energie in Wärmeenergie bereitgestellt. Mehrere Wärmespeicherkassetten werden jeweils ausgehend von einem Kassettenrahmen gebildet, welcher im Querschnitt an drei Seiten geschlossen und an einer vierten Seite geöffnet ist. An dem Kassettenrahmen sind Halterungen zum Halten von Wärmespeicherstangen in einer vorgegebenen Position vorhanden. In jeden Kassettenrahmen werden mehrere Wärmespeicherstangen an der offenen vierten Seite eingeführt werden, sodass die Wärmespeicherstangen durch die Halterungen in Position gehalten werden.

Anschließend wird jeder Kassettenrahmen an der vierten Seite geschlossen, wobei mindestens ein Ende jeder Wärmespeicherstange unfixiert ist (also nicht örtlich befestigt ist), so dass innerhalb des Kassettenrahmens eine freie thermische Expansion der Wärmespeicherstangen in Längsrichtung der Wärmespeicherstangen ermöglicht ist.

### Optionale Gestaltungen

Varianten des erfindungsgemäßen Wärmespeichers und des erfindungsgemäßen Verfahrens sind Gegenstand der abhängigen Ansprüche und werden in der folgenden Beschreibung erläutert.

### Freie thermische Expansion innerhalb des Kassettenrahmens

Ein Kassettenrahmen kann insbesondere aus Metall bestehen und z.B. eine Rechteckform haben. Er umrahmt mehrere oder alle der von diesem Kassettenrahmen gehaltenen Wärmespeicherstangen. Der Kassettenrahmen ist an einer Vorder- und Rückseite offen, so dass ein Wärmetransferfluid an der Vorderseite eintreten, an den Wärmespeicherstangen entlangströmen und an der Rückseite aus dem Kassettenrahmen austreten kann.

In einem fertig montierten Zustand der Wärmespeicherkassetten ist jeder Kassettenrahmen in Längsrichtung der gehaltenen Wärmespeicherstangen geschlossen, so dass die Wärmespeicherstangen nicht in Längsrichtung aus dem Kassettenrahmen austreten können. Um die freie thermische Expansion der Wärmespeicherstangen in Längsrichtung innerhalb eines Kassettenrahmens zu ermöglichen, ist ein Freiraum in jedem Kassettenrahmen in Längsrichtung der gehaltenen Wärmespeicherstangen größer als eine Länge der Wärmespeicherstangen. Falls ein Rahmenteil des Kassettenrahmens Aufnahmelöcher für die Wärmespeicherstangen aufweist, soll der Freiraum als ein Raum bis in die Aufnahmelöcher hinein verstanden werden, so dass er die gesamte Länge umfasst, die für eine Wärmespeicherstange zur Verfügung steht. Falls der Kassettenrahmen keine Aufnahmelöcher für die Wärmespeicherstangen aufweist, erstreckt sich der Freiraum zwischen gegenüberliegenden Teilen des Kassettenrahmens.

Zwischen zumindest einem der Enden einer Wärmespeicherstange (in Längsrichtung) und dem Kassettenrahmen bleibt dadurch eine Lücke. Die Lücke ist so dimensioniert, dass sie größer oder gleich einer thermischen Expansionslänge der gehaltenen Wärmespeicherstangen ist, wenn diese über einen vorgegebenen Auslegungstemperaturbereich des Wärmespeichers erhitzt werden. Der Auslegungstemperaturbereich ist abhängig vom verwendeten Speichermaterial und kann z.B. einen Bereich innerhalb von 0-1000°C abdecken. Ein eigentlicher Betriebstemperaturbereich des Wärmespeichers, das heißt eine maximale und minimale Temperatur während aufeinanderfolgenden Ladungs- und Entladungsphasen des Wärmespeichers, liegt innerhalb des Auslegungstemperaturbereichs und deckt zum Beispiel 200°C bis 550°C oder 180°C bis 600°C ab. Für den Auslegungstemperaturbereich kann eine Minimaltemperatur einer minimal zu erwartenden Umgebungstemperatur entsprechen (z.B. 0°C, während Wartungsphasen oder bei der Inbetriebnahme). Eine Maximaltemperatur des Auslegungstemperaturbereichs kann, z.B. zur Sicherheitserhöhung, mindestens 50-100°C oberhalb der betrieblichen Maximaltemperatur liegen.

Für die Dimensionierung der Lücke zwischen den Wärmespeicherstangen und dem Kassettenrahmen kann auch eine Obergrenze vorgesehen sein, so dass beispielsweise bei einer maximalen Auslegungstemperatur des Wärmespeichers die Lücke höchstens 5cm oder höchstens 1 cm beträgt. Indem unnötig große Lücken vermieden werden, können die Stabilität erhöht und ungewollte Bewegungen der Wärmespeicherstangen, insbesondere bei einem Transport einer Wärmespeicherkassette, reduziert werden. Durch die Planung und Berechnung der Abstände zwischen den einzelnen Stahlstangen, Kassetten, Modulen und Zwischenräumen zueinander, kann die benötigte/ erwünschte (Wärmeübertragungs-) Leistung und Verweilzeit direkt über das resultierende Strömungsprofil des Wärmetransferfluids (Luft/Gas, Thermoöl/Flüssigkeit) im Zuge der Erhöhung oder der Minderung der Strömungsgeschwindigkeit eines Gebläses, Verdichters oder einer Pumpe eingestellt werden und so zielgenau die systemrelevanten Zielparameter für einen Verbraucher oder ein Bedarfselement des Anlagensystems erzeugt und/oder bereitgestellt werden. Dieser Nachsatz kann für alle Auslegungsvarianten des Speichersystems, welche als Teil dieses Patents beschrieben werden, gelten.

### Führungsschiene einer Wärmespeicherkassette

Ein Kassettenrahmen kann mindestens eine Führungsschiene umfassen, welche insbesondere als Lochplatte gebildet sein kann und die Halterungen mitbildet. Jede Führungsschiene erstreckt sich (in Richtung ihrer größten Ausdehnung) senkrecht zur Längsrichtung der Wärmespeicherstangen. Zudem weist jede Führungsschiene mehrere Löcher auf, wobei sich durch jedes Loch eine der Wärmespeicherstangen erstreckt. Die Löcher der Führungsschiene begrenzen somit einen Bewegungsfreiraum der Wärmespeicherstangen in einer Ebene senkrecht zur Längsrichtung der Wärmespeicherstangen und halten so die Wärmespeicherstangen. In Längsrichtung verhindert die Führungsschiene hingegen keine Bewegung der Wärmespeicherstangen, wodurch eine thermische Expansion der Wärmespeicherstangen ermöglicht wird, ohne dass Spannungen zur Führungsschiene auftreten. Daher sind die Wärmespeicherstangen nicht in den Löchern starr befestigt, insbesondere nicht verschweißt, verlötet oder fixierend verschraubt. Der Durchmesser eines Lochs kann im Vergleich zum Durchmesser der aufgenommenen Wärmespeicherstange geringfügig größer sein, beispielsweise um höchstens 0,5 oder 1 cm oder um 1 % bis 7 % des Durchmessers der Wärmespeicherstange.

Eine Führungsschiene kann sich insbesondere zwischen zwei gegenüberliegenden Seiten (-wänden) des Kassettenrahmens erstrecken, wobei diese Seiten parallel zur Längsrichtung der Wärmespeicherstangen verlaufen, und wobei die Führungsschiene an diesen Seiten befestigt ist, z.B. verschweißt, verschraubt oder verriegelt ist.

Die Löcher einer Führungsschiene sind entlang einer Reihe angeordnet. Entsprechend sind die Wärmespeicherstangen einer Wärmespeicherkassette entlang einer Reihe nebeneinander und parallel zueinander angeordnet. Eine Wärmespeicherkassette kann genau eine einzige Reihe an Wärmespeicherstangen umfassen, wodurch die Problematik einer möglicherweise ungleichmäßigen Temperaturverteilung in der Richtung senkrecht zur Reihe und senkrecht zur Längsrichtung der Wärmespeicherstangen zu keinen relevanten Materialspannungen innerhalb einer Wärmespeicherkassette führen kann. Prinzipiell können auch zwei oder drei Reihen an Wärmespeicherstangen in einer einzigen Wärmespeicherkassette gehalten sein, wozu die Führungsschiene zwei oder drei Reihen an Löchern umfassen kann, wobei wegen möglichen temperaturbedingten Spannungen jedoch nicht allzu viele Reihen vorhanden sein sollten.

Umfasst ein Kassettenrahmen mehrere Führungsschienen, so können diese parallel zueinander angeordnet und in Längsrichtung der Wärmespeicherstangen zueinander versetzt sein.

Eine Führungsschiene kann einstückig gebildet sein. Alternativ ist auch eine zwei- oder mehrteilige Gestaltung möglich. Bei einer zweiteiligen Ausführung kann jedes Schienenteil einen Randabschnitt von jedem Loch der Führungsschiene bilden, so dass die Löcher erst durch beide Schienenteile in Umfangsrichtung geschlossen sind (bis auf einen optionalen Spalt zwischen den Schienenteilen). Durch die zweiteilige Ausführung kann im Zusammenbau zunächst ein Schienenteil am Kassettenrahmen befestigt werden, anschließend werden die Wärmespeicherstangen im Kassettenrahmen positioniert und danach wird das zweite Schienenteil am Kassettenrahmen befestigt, womit die Löcher der Führungsschiene geschlossen werden.

Für einen sicheren Halt einer Wärmespeicherstange innerhalb des Kassettenrahmens sollte jede Wärmespeicherstange an mindestens zwei oder mindestens drei Stellen gehalten werden. Unter einem Halten wird hier eine Beschränkung des Bewegungsraums senkrecht zur Längsrichtung der Wärmespeicherstange verstanden. Ein Halten an mindestens zwei Stellen kann durch Verwendung einer entsprechenden Anzahl an Führungsschienen realisiert werden. Anstelle einer Führungsschiene können aber auch an einem Ende oder an beiden gegenüberliegenden Enden des Kassettenrahmens Aufnahmen zum Halten der Wärmespeicherstangen gebildet sein, wie nachfolgend erläutert.

### Aufnahmen für Wärmespeicherstangen an den Enden des Kassettenrahmens

Jeder Kassettenrahmen hat eine Rahmengrundseite und eine gegenüberliegende Rahmenstirnseite. Diese beiden Seiten können sich quer bzw. senkrecht zur Längsrichtung der Wärmespeicherstangen erstrecken. Der Kassettenrahmen kann an der Grundseite und/oder der Stirnseite mindestens ein Rahmenteil umfassen, welches hohl sein kann und einen z.B. rechteckigen Querschnitt aufweisen kann.

Das Rahmenteil der Grundseite und/oder das Rahmenteil der Stirnseite kann Aufnahmelöcher oder Aufnahmevertiefungen als Stützung der Wärmespeicherstangen aufweisen und so einen Teil der vorgenannten Halterungen bilden. Die Aufnahmelöcher können gleich gebildet sein wie die Löcher der Führungsschiene. Die Aufnahmelöcher oder Aufnahmevertiefungen befinden sich auf derjenigen Seite des Rahmenteils, welche einem Innenbereich des Kassettenrahmens zugewandt ist. Auf einer hierzu gegenüberliegenden Außenseite des Rahmenteils, welche den Kassettenrahmen nach außen begrenzt, sind hingegen keine Löcher vorhanden, durch welche eine Wärmespeicherstange austreten könnte. Die beiden Rahmenteile der Grundseite und der Stirnseite begrenzen somit in Längsrichtung den innerhalb des Kassettenrahmens verfügbaren Freiraum für die Wärmespeicherstangen. Der Freiraum wird durch die maximal zu erwartende thermische Dehnung der Wärmespeicherstangen (+Toleranz) bestimmt. Der durch die Aufnahmelöcher / Aufnahmevertiefungen bereitgestellte Raum ist Teil des genannten Freiraums, womit sich der Freiraum bis in ein (hohles) Rahmenteil hineinerstreckt. Wie bereits in ähnlicher Weise beschrieben, ist dieser Freiraum hinreichend groß bemessen, so dass bei maximaler Auslegungstemperatur des Wärmespeichers eine thermische Expansion der Wärmespeicherstangen nicht dazu führt, dass eine Wärmespeicherstange gegen sowohl das Rahmenteil der Grundseite als auch das Rahmenteil der Stirnseite stößt. Die vorgenannte Auslegungstemperatur kann höher als eine maximale Betriebstemperatur sein und ist relevant für die Dimensionierung des Abstands zwischen den Aufnahmelöchern der Führungsschiene und der Begrenzung des oberen Rahmenteils, bis zu welcher sich die Wärmespeicherstangen maximal erstrecken können. Für diese Dimensionierung werden fertigungstechnische ebenso wie bauteil- und werkstoffspezifische sowie sicherheitstechnische Toleranzen berücksichtigt. Außerdem sind die zu berechnenden prozesstechnischen Auslegungsparameter (z.B. Druck-, Temperaturverlauf und/oder Strömungsprofil) für die vorgenannte Dimensionierung relevant. Die Wärmespeicherstangen können vertikal ausgerichtet sein und auf der Grundseite des Rahmens stehen, so dass die Wärmespeicherstangen ihr Eigengewicht tragen. Die Löcher, die an einem oder an beiden Rahmenteilen vorgesehen sein können, bieten zusätzlich einen Halt senkrecht zur Längsrichtung. Um Wärmeverluste in den Boden zu reduzieren, kann eine keramische Schicht als Aufstandsfläche oder eine isolierte Bodenplatte aus schlecht wärmeleitendem Material genutzt werden.

Prinzipiell können die Wärmespeicherstangen auf der Grundseite fixiert werden, wobei jedoch aufgrund der beschriebenen Ausführungen vorteilhafterweise auf eine Fixierung verzichtet werden kann.

Prinzipiell können die Halterungen zum Halten der Wärmespeicherstangen allein durch die Rahmenteile der Grundseite und Stirnseite gebildet sein, ohne dass eine Führungsschiene verwendet wird. Für eine einfachere Montage und zur Erhöhung der Stabilität kann es aber bevorzugt sein, dass zusätzlich mindestens eine Führungsschiene vorhanden ist. Bei vertikaler Ausrichtung der Wärmespeicherstangen können dadurch potentiell gefährliche Kippmomente vermieden werden. Außerdem können kleinere Deformierungen, die innerhalb der Speicherelemente infolge des zyklischen Erwärmens und Abkühlens des Wärmespeichers auftreten könnten, wirksam verringert bzw. unterdrückt werden.

### Wärmespeicherstangen

Die Wärmespeicherstangen können aus einem Metall bzw. einer Metalllegierung bestehen. Prinzipiell sind verschiedene Metalle und Metalllegierungen möglich, wobei ein Stahl hinsichtlich der Robustheit, Wärmekapazität, hoher Verfügbarkeit und Lebensdauer sowie sehr guter Recyclebarkeit besonders geeignet sein kann. Jede Wärmespeicherstange kann einstückig gebildet sein, um so etwaige Spannungen zu vermeiden, welche sonst an Kontaktstellen der zu verbindenden Teile (z.B. Stoffschluss über Schweißnaht oder Kleber) auftreten könnten. Die mehreren Wärmespeicherstangen, die in einem Kassettenrahmen gehalten sind, können dieselbe Form und Größe haben. Eine zylindrische Form ermöglicht es, in einfacher Weise mehrere Wärmespeicher nah nebeneinander in einem Kassettenrahmen zu halten, ohne dass durch thermische Expansionen ein ungewollter Kontakt zwischen den Wärmespeicherstangen droht. Die Querschnittsform einer Wärmespeicherstange kann prinzipiell beliebig sein. Eine runde oder kreisförmige Querschnittsform kann bevorzugt sein, um in leichter Weise die Wärmespeicherstangen in Löcher der Führungsschiene und in Aufnahmelöcher des Kassettenrahmens einzuführen. Komplexere Formen, z.B. eine T-Form oder Doppel-T-Form, können bevorzugt sein, um die Oberfläche zu erhöhen und so einen schnelleren Wärmetransfer zu ermöglichen. Eine Form der Löcher der Führungsschiene kann mit der Querschnittsform der Wärmespeicherstangen übereinstimmen. Die Querschnittsform kann auch ein N-Eck bilden, welches z.B. drei, vier, fünf, sechs oder mehr Ecken aufweist. Abhängig von der Querschnittsform kann ein erhöhtes (Wärme-) Übertragungsvermögen erreicht werden, wobei dieser Vorteil jedoch gegen den von der Querschnittsform abhängigen Druckverlust des Wärmetransferfluids sowie den höheren bauplatztechnischen Bedarf und somit die zusätzlich anfallenden Kosten und Aufwände abzuwiegen ist.

### Wärmespeichermodul

Der Wärmespeicher kann mehrere Wärmespeichermodule aufweisen. Jedes Wärmespeichermodul umfasst einen Modulrahmen, welcher dazu eingerichtet ist, mehrere der Wärmespeicherkassetten zu halten. Optional ist der Modulrahmen auch dazu eingerichtet, mindestens eine elektrische Heizvorrichtung zu halten. Das Halten erfolgt ohne Fixierung, insbesondere ohne Verschweißung, Verlötung, Verschraubung oder Vernieten der Wärmespeicherkassetten oder der elektrischen Heizvorrichtung am Modulrahmen. Dadurch werden Materialspannungen zwischen dem Modulrahmen und den Wärmespeicherkassetten oder der elektrischen Heizvorrichtung vermieden, welche durch Temperaturunterschiede bzw. thermische Expansionen der genannten Komponenten auftreten könnten.

Indem mehrere Wärmespeichermodule mit jeweils eigenem Modulrahmen verwendet werden, können zudem mechanische Spannungen im Modulrahmen aufgrund von Temperaturunterschieden innerhalb des gesamten Wärmespeichers gering gehalten werden. Die mehreren Modulrahmen sind wiederum nicht miteinander fixiert, insbesondere also nicht verschweißt oder unbeweglich verschraubt. Es können zumindest einige der Wärmespeichermodule hintereinander angeordnet sein, so dass sie von durchströmendem Wärmetransferfluid nacheinander durchströmt werden, und ihre Modulrahmen keine starre Fixierung zueinander umfassen.

Eine Wärmespeicherkassette hat eine Länge, die im Wesentlichen durch die Länge der Wärmespeicherstangen bestimmt ist. Dadurch ist die thermische Ausdehnung der Wärmespeicherkassette in Längsrichtung in der Regel größer als in Richtungen senkrecht hierzu. Durch den Halt der Wärmespeicherkassetten in einem Wärmespeichermodul sollte daher in Längsrichtung eine thermische Expansion spannungsfrei ermöglicht werden. Hierzu kann jeder Modulrahmen an zwei gegenüberliegenden Seiten jeweils mehrere Aufnahmenuten für einen jeweiligen Vorsprung oder Randabschnitt einer der Wärmespeicherkassetten aufweisen. Eine Wärmespeicherkassette wird somit in zwei gegenüberliegenden Aufnahmenuten gehalten bzw. vor einem Umkippen geschützt. Die Nuten verlaufen parallel zur Längsrichtung der Wärmespeicherstangen. Während die Nuten einen Halt in der Ebene senkrecht zur Längsrichtung gewährleisten, schränken die Nuten die Beweglichkeit (aufgrund einer thermischen Expansion) der Wärmespeicherkassette mit den Wärmespeicherstangen in Längsrichtung nicht ein. Die Breite des Modulrahmens (das heißt der Abstand zwischen zwei gegenüberliegenden Nuten) und die Nutentiefe sind im Hinblick auf eine thermische Expansion der Wärmespeicherkassette gewählt: Der Abstand zwischen den Nuten ist klein genug, dass bei minimaler Betriebstemperatur die Randabschnitte der Wärmespeicherkassette noch in die Nuten hineinragen. Die Nutentiefe ist zudem so groß gewählt, dass bei maximaler Betriebstemperatur eine thermische Expansion der Wärmespeicherkassette nicht dazu führt, dass die Wärmespeicherkassette einen Nutboden von beiden gegenüberliegenden Nuten berührt. Durch diese Dimensionierung wird ein sicherer Halt über den gesamten Betriebstemperaturbereich gewährleistet, ohne dass es zu mechanischen Spannungen zwischen dem Modulrahmen und der Wärmespeicherkassette aufgrund thermischer Expansionen kommt.

Um eine elektrische Heizvorrichtung zu halten, kann jeder Modulrahmen an zwei gegenüberliegenden Seiten jeweils mindestens eine Heizvorrichtung-Aufnahmenut für einen jeweiligen Randabschnitt der elektrischen Heizvorrichtung aufweisen. Die obigen Beschreibungen zu den Aufnahmenuten für die Wärmespeicherkassetten können sinngemäß auch für die Heizvorrichtung-Aufnahmenuten gelten. Die Form und Größe einer Heizvorrichtung-Aufnahmenut kann allgemein gleich oder verschieden zur Form und Größe der Aufnahmenuten für die Wärmespeicherkassetten sein.

In einem Wärmespeichermodul können zunächst mehrere Wärmespeicherkassetten hintereinander angeordnet sein, ehe eine elektrische Heizvorrichtung folgt, auf welche wiederum mehrere Wärmespeicherkassetten folgen. Hierdurch kann eine gleichmäßigere Erwärmung erzielt werden als in einem Fall, dass die elektrische Heizvorrichtung nicht zwischen den Wärmespeicherkassetten angeordnet ist.

Die oben genannten Randabschnitte, welche in die Nuten hineinragen, können z.B. als Vorsprünge oder hervorstehende Schienen gestaltet sein. Die Randabschnitte und Nuten können sich über im Wesentlichen die gesamte Länge (z.B. mindestens 80% oder mindestens 90% der Länge) der Wärmespeicherstangen erstrecken. Alternativ können die Nuten und/oder Randabschnitte auch nur an einem oder mehreren kürzeren Bereichen vorhanden sein, welche z.B. nicht mehr als 10% oder 15% der Länge der Wärmespeicherstangen überspannen.

Die Aufnahmenuten und in diese hineinragende Randabschnitte können auch vertauscht sein: In diesem Fall umfassen die Wärmespeicherkassetten an zwei gegenüberliegenden Außenseiten jeweils eine Nut, in welche ein Vorsprung des Modulrahmens hineinragt. Ebenso kann die elektrische Heizvorrichtung an zwei gegenüberliegenden Außenseiten eine Nut aufweisen, in welche ein Vorsprung des Modulrahmens hineinragt.

Manche oder alle der Wärmespeichermodule können über Temperatursensoren verfügen. Ein Wärmespeichermodul kann Temperatursensoren in unterschiedlicher Höhe umfassen und an unterschiedlichen Stellen entlang der Strömungsrichtung durch das Wärmespeichermodul, beispielsweise zwischen zwei Wärmespeicherkassetten und direkt neben der elektrischen Heizvorrichtung.

### Stehende Anordnung eines Wärmespeichermoduls

Mehrere oder alle der Wärmespeicherkassetten können aufrecht angeordnet sein, so dass die Längsrichtung der Wärmespeicherstangen vertikal ausgerichtet ist. Die Wärmespeicherstangen stehen hierbei auf einem Kassettenrahmenboden, so dass sie in vertikaler Richtung, nach oben, frei thermisch expandieren können. Der Kassettenrahmenboden kann gerade das vorgenannte Rahmenteil der Grundseite sein, welches optional Aufnahmelöcher /-vertiefungen aufweist.

Eine vertikale Anordnung hat unter anderem den Vorteil, dass die Gefahr eines Durchbiegens der Wärmespeicherstangen und einer Stabilitätsbeeinträchtigung des gesamten Wärmespeichers reduziert ist. Eine Wärmespeicherstange kann z.B. zwischen 5 m und 10 m lang sein, wodurch die Anforderungen an die Halterungen entsprechend hoch sind. Bei vertikaler Anordnung bilden die Halterungen einen Kippschutz für die Wärmespeicherstangen, tragen jedoch nicht das Gewicht der Wärmespeicherstangen. Entsprechend ist die Belastung der Halterungen geringer und diese können einfacher designt werden.

Bei Verwendung der beschriebenen Wärmespeichermodule gilt die vertikale Anordnung jeweils für ein Wärmespeichermodul, das heißt für alle darin gehaltenen Wärmespeicherkassetten. Die Wärmespeicherkassetten von einem der Wärmespeichermodule stehen auf einer Bodenplatte dieses Wärmespeichermoduls, so dass die Bodenplatte das Gewicht der Wärmespeicherkassetten trägt. Die Bodenplatte und der Modulrahmen sind miteinander befestigt, z.B. verschweißt, verschraubt oder verlötet. Hingegen sind die Bodenplatte und die Wärmespeicherkassetten nicht miteinander befestigt, um Materialspannungen durch thermische Expansionen zu vermeiden. Ein Umkippen der Wärmespeicherkassetten wird verhindert, indem Randabschnitte der Wärmespeicherkassetten in Aufnahmenuten an Seiten des Wärmespeichermoduls hineinragen.

Die Wärmespeichermodule, die den Wärmespeicher bilden, können alle stehend, teilweise auch liegend oder ausschließlich liegend angeordnet sein.

### Liegende Anordnung eines Wärmespeichermoduls

Ein Wärmespeichermodul kann liegend angeordnet sein, so dass die Längsrichtung der Wärmespeicherstangen dieses Wärmespeichermoduls horizontal ausgerichtet sind. Zwei verschiedene liegende Anordnungen sind für das Wärmespeichermodul möglich. Diese unterscheiden sich darin, ob eine Wärmespeicherkassette flach liegt (so dass eine Reihe gehaltener Wärmespeicherstangen auf gleicher Höhe ist), oder eine Wärmespeicherkassette auf ihrer Seitenwand steht (so dass die Längsrichtung der Wärmespeicherstangen zwar ebenfalls horizontal ausgerichtet ist, aber die gehaltenen Wärmespeicherstangen derselben Wärmespeicherkassette in vertikaler Richtung aufgereiht sind).

Bei einer liegenden Anordnung tragen die Halterungen das Gewicht der Wärmespeicherstangen. Die Halterungen stützen jede Wärmespeicherstange an mindestens zwei Stellen, ohne Fixierung der Wärmespeicherstange, um die freie thermische Expansion der Wärmespeicherstangen in Längsrichtung zu gewährleisten.

Die Abmessung der Wärmespeicherkassette in vertikaler Richtung kann bei einer liegenden Anordnung niedriger sein als bei vertikaler Anordnung. Diese Höhe ist relevant für die Strömung eines Wärmetransferfluids durch die Wärmespeicherkassette. Da ein erwärmtes Wärmetransferfluid aufsteigt, könnte es bei einer übermäßigen Höhe zu einem ungleichmäßigen Wärmetransfer kommen. Diese Problematik wird bei einer liegenden Anordnung im Wesentlichen umgangen. Ein klar begrenzter (Strömungs-) Raum kann durch die obere Wand zusammen mit der unteren Platte vorgegeben werden. Die Höhenunterschiede zwischen der oberen Wand und der unteren Platte sind bei der liegenden Anordnung zu gering, um eine signifikante Temperaturdifferenz des Stahls von oberen zu unteren Stahlstreben hervorzurufen.

### Strömung des Wärmetransferfluids

Ein Wärmetransferfluid kann insbesondere ein beliebiges Gas oder Gasgemisch sein. Es können Ventilatoren, Pumpen oder andere Einrichtungen zum Befördern des Wärmetransferfluids vorhanden sein, so dass eine Strömung des Wärmetransferfluids durch die Wärmespeichermodule hindurch (entlang der Wärmespeicherstangen) erfolgt. Allgemein könnte auch eine Flüssigkeit als Wärmetransferfluid dienen.

Indem das Wärmetransferfluid an erhitzten Wärmespeicherstangen entlangströmt, kann es Wärme von den Wärmespeicherstangen aufnehmen, welche aus dem Wärmespeicher abgeführt werden kann. Hierzu kann z.B. ein Wärmetauscher dienen. Je nach Gestaltung des Wärmespeichers kann das Wärmetransferfluid auch dem Zuführen von Wärmeenergie zu den Wärmespeicherstangen dienen. So kann das Wärmetransferfluid von den elektrischen Heizeinrichtungen erhitzt werden und daraufhin Wärmeenergie an die Wärmespeicherstangen abgeben. Der Wärmetransfer während der Ladephase kann hauptsächlich auf konvektiver Wärmeübertragung von den heißen elektrischen Heizelementen auf das Wärmeträgerfluid und den Stahlkomponenten/ Speicherstahlstangen beruhen. Während der Entladung des heißen Speichers geben die Stahlstangen und Heizelemente wiederum die Wärme an das Fluid ab. Hierbei ist auch die gleichzeitige Ladung und Entladung des Speichers möglich. Prinzipiell können die elektrischen Heizeinrichtungen auch direkt an den Wärmespeicherstangen Wärmeenergie erzeugen. Dadurch leistet das Wärmetransferfluid während einer reinen Ladephase keinen oder keinen großen Beitrag zu einem Wärmetransfer zu den Wärmespeicherstangen.

### Elektrische Heizvorrichtung

Die mindestens eine elektrische Heizvorrichtung kann prinzipiell beliebig gestaltet sein, um elektrische Energie in Wärmeenergie umzuwandeln. Dies kann beispielsweise durch resistives Heizen erfolgen, wobei aufgrund des elektrischen Widerstands eines stromdurchflossenen Materials Wärme entsteht.

Die elektrische Heizvorrichtung kann mehrere elektrische Leitungen umfassen, die von Strom durchflossen werden und so Wärme erzeugen. Das Wärmetransferfluid kann an den Leitungen entlang strömen, um in manchen Ausführungsformen Wärme von den Leitungen aufzunehmen und danach an die Wärmespeicherstangen abzugeben. In anderen Ausführungsformen dient das Wärmetransferfluid im Wesentlichen allein einer Wärmeabfuhr weg von erhitzten Wärmespeicherstangen.

In verschiedenen Ausführungsvarianten ist eine elektrische Heizeinrichtung zwischen zwei Wärmespeicherkassetten angeordnet. Allgemeiner kann eine elektrische Heizeinrichtung aber auch an beliebiger anderer Stelle entlang eines Strömungspfads oder -kreislaufes des Wärmetransferfluids angeordnet sein. Prinzipiell kann die mindestens eine elektrische Heizvorrichtung auch in einem separaten Kreislauf angeordnet sein, in welchem ein Fluid erhitzt wird, welches sodann über einen Wärmetauscher Wärme an das Wärmetransferfluid abgibt. Das Fluid an der elektrischen Heizvorrichtung kommt dann nicht selbst mit den Wärmespeicherstangen in Kontakt. Ein solcher separater Kreislauf kann auch als Vorerhitzer dienen und mit weiteren elektrischen Heizvorrichtungen im Kreislauf des Wärmetransferfluids kombiniert werden.

Für eine gleichmäßige Wärmezufuhr kann es bevorzugt sein, wenn mehrere oder alle der Wärmespeichermodule jeweils (mindestens) eine elektrische Heizvorrichtung aufweisen. Genau eine elektrische Heizvorrichtung kann zum Bilden einer Vielzahl verhältnismäßig kompakter Wärmespeichermodule vorteilhaft sein, weil hierdurch Materialspannungen aufgrund von Temperaturunterschieden innerhalb eines Wärmespeichermoduls klein gehalten werden.

Die elektrischen Leitungen der elektrischen Heizvorrichtungen können mäanderförmig verlaufen und so eine Fläche abdecken, welche im Wesentlichen der Fläche des Innenraums einer Wärmespeicherkassette, oder einem Großteil dieser Fläche, z.B. mindestens 70%, entspricht. Hierzu können sich die elektrischen Leitungen der elektrischen Heizvorrichtungen über die Länge der Wärmespeicherstangen erstrecken, bzw. über mindestens 80% dieser Länge. Zudem erstreckt sich die Mäanderform der elektrischen Leitungen in einer Breitenrichtung (d.h. in einer Richtung, welche senkrecht zur Längsrichtung steht und parallel zur Hauptrichtung der Führungsschiene) über mindestens 80% der Breite einer Wärmespeicherkassette.

Sowohl eine Wärmespeicherkassette als auch eine elektrische Heizvorrichtung können insgesamt eine (insbesondere rechteckige) Plattenform haben, das heißt ihre Länge und Breite sind mindestens 5 mal größer als ihre Tiefe. Die verhältnismäßig geringe Tiefe ist für eine große Oberfläche und damit einen hohen Wärmeaustausch wichtig und umgeht die Problematik stärkerer thermischer Expansionen oder mechanischer Spannungen in der Tiefenrichtung.

Eine elektrische Heizvorrichtung kann eine Trägerstange aufweisen, welche am Modulrahmen gehalten oder getragen wird. Die Trägerstange kann in der Breitenrichtung über die Fläche der mäanderförmig verlaufenden elektrischen Leitungen hinausragen. Zudem kann die Trägerstange an einem Ende des Modulrahmens, neben den Enden der Wärmespeicherstangen, angeordnet sein. Die elektrischen Leitungen verlaufen von der Trägerstange aus in den Innenbereich des Modulrahmens, das heißt in den vom Modulrahmen umrahmten Bereich. Hingegen verlaufen elektrische Zuleitungen auf der gegenüberliegenden Seite der Trägerstange. Die elektrischen Zuleitungen sind elektrisch mit den zum Heizen genutzten elektrischen Leitungen verbunden, sollen jedoch nicht ebenfalls einem Heizen dienen. Daher haben die Zuleitungen einen kleineren elektrischen Widerstand als die elektrischen Leiter. Die elektrischen Zuleitungen führen zu einer Anschlussbox, in welcher sich elektrische Anschlusspunkte zum Anschließen von Kabeln befinden. Indem die Anschlussbox beabstandet von dem Innenraum des Modulrahmens ist, können die Anschlusspunkte in der Anschlussbox sowie dort angeschlossene Kabel weitgehend vor den hohen Temperaturen geschützt werden, welche im Innenraum des Modulrahmens vorliegen können. Über die Kabel wird eine Verbindung zu einer speicherprogrammierbaren Steuerung (SPS) hergestellt, welche elektronische Komponenten zur Steuerung oder Überwachung der elektrischen Heizvorrichtung und optional anderer Komponenten des Wärmespeichers umfasst. Beispielsweise kann die SPS auch eine Elektronik zum Auswerten von Temperaturmessdaten umfassen, insbesondere um anhand eines Temperaturanstiegs die Fehlersituation zu erkennen, dass ein Lüfter, ein Verdichter oder eine Pumpe ausgefallen ist, aber die elektrische Heizvorrichtung noch weiter heizt. Indem die SPS beabstandet von erhitzten Bereichen des Wärmespeichers angeordnet ist, werden die elektrischen Zuleitungen und Anschlusskabel sowie die SPS vor übermäßigen Temperaturen geschützt. Es kann vorgesehen sein, dass die (Stromzufuhr-) Kabel der Heizelemente, welche einem Netzanschluss dienen, an der Anschlussbox angeschlossen werden; hingegen können beispielsweise Kabel von Thermo- und Drucksensoren direkt mit der sich einige Meter entfernt befindlichen SPS verbunden werden. In einem zusammengebauten Zustand eines Wärmespeichermoduls ragen allein die elektrischen Zuleitungen und die Anschlussbox nach außen vom Modulrahmen hervor, während die Wärmespeicherkassetten und die elektrischen Leitungen der Heizvorrichtung innerhalb des Modulrahmens angeordnet sind. Zwischen der Anschlussbox und dem Modulrahmen kann ein Dämmmaterial zur thermischen Isolierung vorhanden sein.

### Zusammenbau einer Wärmespeicherkassette und eines Wärmespeichers

Wie bereits teilweise beschrieben, kann mit einem Kassettenrahmen begonnen werden, welcher an drei Seiten geschlossen ist. Diese drei Seiten können als Bodenseite und zwei Seitenwände bezeichnet werden. Die vierte Seite des Kassettenrahmens (d.h. das obere Rahmenteil) wird erst später geschlossen. Die Wärmespeicherstangen können dadurch über die geöffnete vierte Seite eingeführt werden, z.B. von einem Kran oder anderen Hebezeugen hineingehoben werden. Die Halterungen verhindern hierbei ein Umkippen der Wärmespeicherstangen. Vorzugsweise wird bei geöffneter vierter Seite jede Wärmespeicherstange an mindestens zwei Stellen von den Halterungen in Position gehalten, wodurch eine präzise Positionierung und ein sicherer Halt gewährleistet werden. Anschließend wird das obere Rahmenteil aufgesetzt, welches wie beschrieben Aufnahmelöcher für die Wärmespeicherstangen aufweisen kann. Das obere Rahmenteil wird mit den Seitenwänden des Kassettenrahmens befestigt, z.B. verschweißt. Dieser Zusammenbau kann stehend erfolgen, so dass die Wärmespeicherstangen vertikal ausgerichtet sind.

Anschließend kann ein Transport der Wärmespeicherkassetten erfolgen, was liegend erfolgen kann (die Längsrichtung der Wärmespeicherstangen liegt in einer Horizontalen). Aufgrund der beschriebenen Gestaltung werden die Wärmespeicherstangen im Kassettenrahmen weiterhin in Position gehalten.

An einem Einsatzort des Wärmespeichers können die Wärmespeichermodule zusammengebaut werden. Hierzu wird ein Modulrahmen mit Bodenplatte am finalen Ort platziert. Eine Wärmespeicherkassette wird per Kran gehoben und so auf die Bodenplatte des Wärmespeichermoduls gestellt, dass die seitlichen Vorsprünge der Wärmespeicherkassette in entsprechende Nuten des Modulrahmens eingreifen. Dies erfolgt für alle Wärmespeicherkassetten und elektrischen Heizvorrichtungen.

In der beschriebenen Weise kann ein Wärmespeicher montiert werden, in welchem mechanische Spannungen durch thermische Expansionen weitgehend eliminiert werden können. Dazu wird auf starre Befestigungen der Wärmespeicherstangen, der elektrischen Heizvorrichtung und der Wärmespeicherkassetten relativ zu ihrer Umgebung verzichtet. Für genügend mechanische Stabilität sorgen dabei die beschriebenen Halterungen.

### Betrieb des Wärmespeichers

Der Wärmespeicher kann zugeführte elektrische Energie mittels der elektrischen Heizvorrichtung in Wärme umwandeln (Laden des Wärmespeichers). Ein durch den Wärmespeicher strömendes Wärmetransferfluid kann einerseits der Verteilung von erzeugter Wärme der Heizvorrichtung dienen, andererseits auch zum Entnehmen von Wärmeenergie aus dem Wärmespeicher (Entladen). Zum Entladen kann das erhitzte Wärmetransferfluid an sich entnommen werden oder alternativ in mindestens einem Wärmetauscher Wärme abgeben, ohne dass das Wärmetransferfluid selbst den Wärmespeicher verlässt. Ein Wärmetauscher kann somit innerhalb oder außerhalb des Wärmespeichergehäuses, in welchem im Betrieb hohe Temperaturen vorherrschen können, angeordnet sein.

Das Laden des Wärmespeichers kann zeitlich variabel erfolgen. Insbesondere kann abhängig von einem Überschuss elektrischer Energie in einem externen Stromnetz oder von einem verbundenen Erzeuger (z.B. einer Windkraftanlage oder eines Photovoltaik-Parks) die elektrische Heizvorrichtung eingeschaltet oder ausgeschaltet werden. Ebenso kann das Entladen zeitlich variabel erfolgen. Ein Laden und Entladen sind auch gleichzeitig möglich.

### Allgemeine Eigenschaften

In Bezug auf sich gleichende Größenangaben kann der Begriff "im Wesentlichen" eine Abweichung von höchstens 5% bezeichnen. Zwei im Wesentlichen gleich große Längen oder Flächen weichen demnach um höchstens 5% voneinander ab.

Die als zusätzliche Vorrichtungsmerkmale beschriebenen Eigenschaften der Erfindung sollen auch für Varianten des erfindungsgemäßen Verfahrens gelten.

### KURZBESCHREIBUNG DER FIGUREN

Weitere Wirkungen und Merkmale der Erfindung werden nachstehend mit Bezug auf die beigefügten schematischen Figuren beschrieben:
- FIG. 1: zeigt eine Wärmespeicherkassette eines Ausführungsbeispiels eines erfindungsgemäßen Wärmespeichers;
- FIG. 2: zeigt einen Kassettenrahmen der Wärmespeicherkassette;
- FIG. 3: zeigt Details der Wärmespeicherkassette;
- FIG. 4: zeigt eine elektrische Heizvorrichtung des Ausführungsbeispiels des erfindungsgemäßen Wärmespeichers;
- FIG. 5: zeigt einen Modulrahmen eines Wärmespeichermoduls des Ausführungsbeispiels des erfindungsgemäßen Wärmespeichers;
- FIG. 6: zeigt den Modulrahmen aus FIG. 5 mit elektrischer Heizvorrichtung;
- FIG. 7: zeigt ein stehendes Wärmespeichermodul des Ausführungsbeispiels des erfindungsgemäßen Wärmespeichers;
- FIG. 8: zeigt ein liegendes Wärmespeichermodul eines Ausführungsbeispiels eines erfindungsgemäßen Wärmespeichers;
- FIG. 9: zeigt ein Ausführungsbeispiel eines erfindungsgemäßen Wärmespeichers;
- FIG. 10: zeigt den Wärmespeicher aus FIG. 9 in einer perspektivischen Schnittansicht;
- FIG. 11: zeigt ein weiteres Ausführungsbeispiel eines erfindungsgemäßen Wärmespeichers; und
- FIG. 12: zeigt eine Perspektivansicht des Wärmespeichers aus FIG. 11.

### DETAILLIERTE BESCHREIBUNG VON AUSFÜHRUNGSBEISPIELEN

Verschiedene Ausführungsbeispiele werden nachstehend mit Bezug auf die Figuren beschrieben. Gleiche und gleich wirkende Bestandteile sind in der Regel mit denselben Bezugszeichen gekennzeichnet.

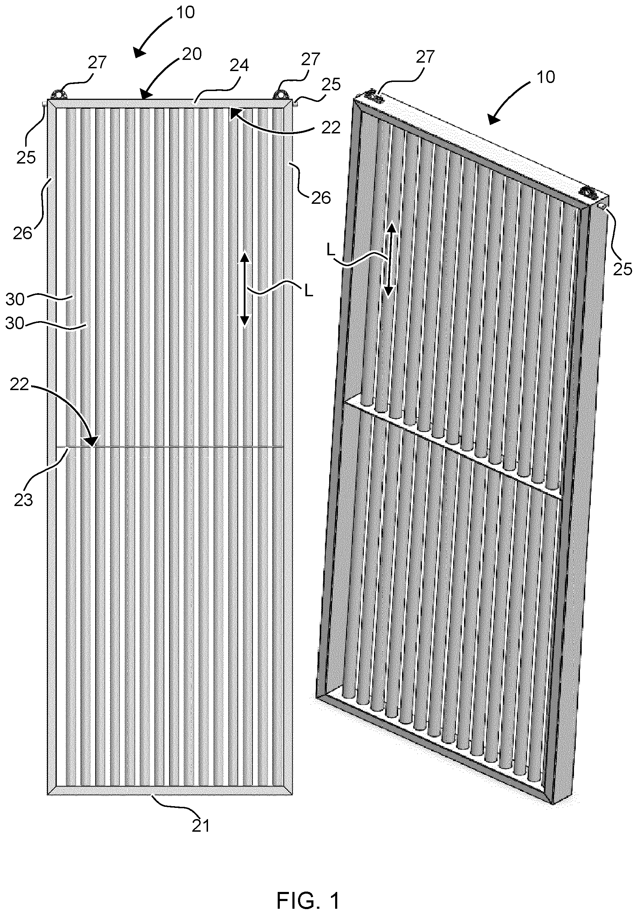

### FIG. 1 bis 3: Wärmespeicherkassetten

Mit Bezug auf die FIG. 1 bis 3 wird eine Wärmespeicherkassette eines Ausführungsbeispiels eines erfindungsgemäßen Wärmespeichers beschrieben. Die Wärmespeicherkassette dient der Speicherung von Wärmeenergie. Die Wechselwirkung zu übrigen Komponenten des Wärmespeichers wird anschließend mit Bezug auf weitere Figuren erläutert.

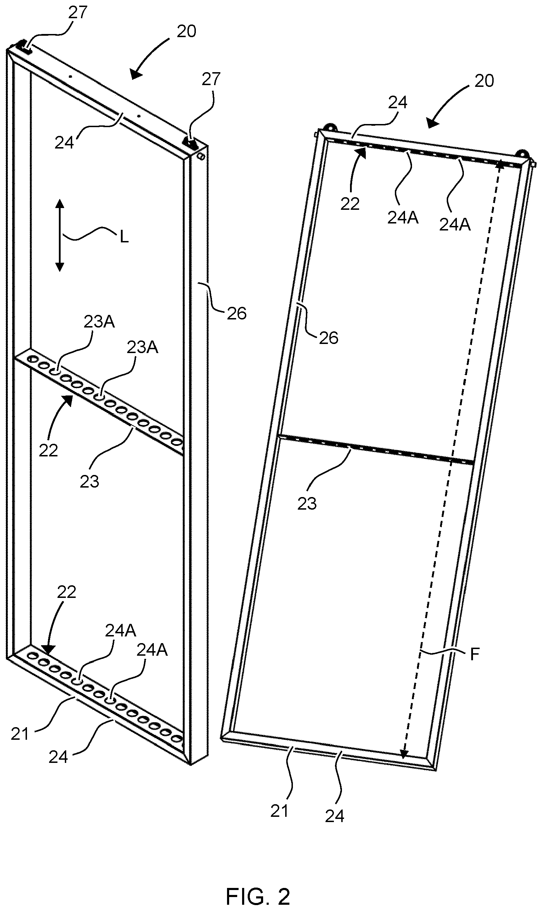

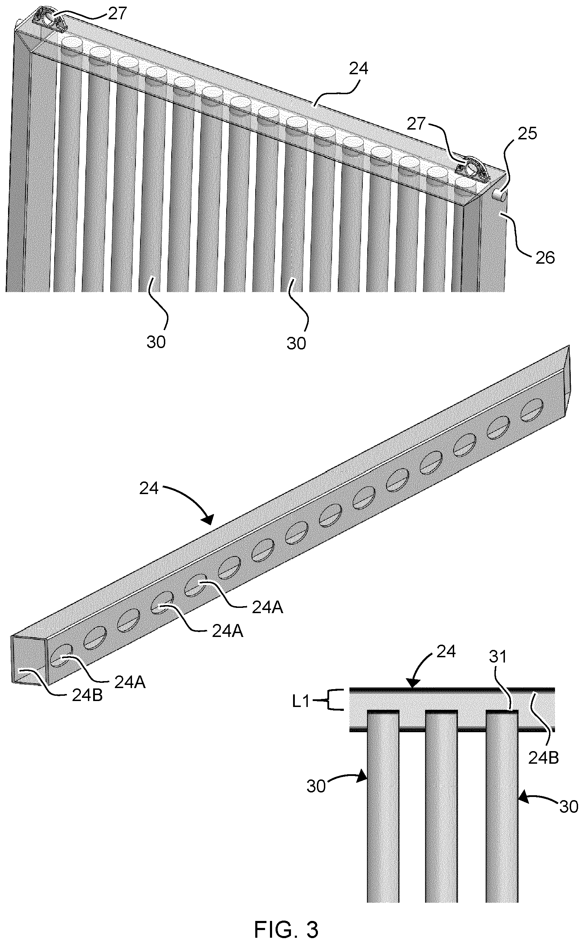

FIG. 1 zeigt eine Frontalansicht einer Wärmespeicherkassette 10 (links) sowie eine Schrägansicht derselben Wärmespeicherkassette (rechts). Die Wärmespeicherkassette 10 umfasst einen Kassettenrahmen 20 und mehrere darin gehaltene Wärmespeicherstangen 30. FIG. 2 zeigt zwei perspektivische Ansichten des Kassettenrahmen 20 ohne die Wärmespeicherstangen. FIG. 3 zeigt vergrößert Ausschnitte bzw. Elemente der Wärmespeicherkassette 10.

Wie in FIG. 1 gezeigt, werden mehrere Wärmespeicherstangen 30 in einer Wärmespeicherkassette 10 gehalten. Die Wärmespeicherstangen 30 können z.B. 5-9m lang sein und ein Gewicht der Wärmespeicherkassette kann im Bereich von 1000-7000kg liegen. Die Wärmespeicherstangen 30 sind entlang einer Reihe angeordnet und werden durch Halterungen 22 in einer vorgegebenen Position relativ zum Kassettenrahmen 20 gehalten. Dieser Halt erfolgt ohne Fixierung oder starre Befestigung, so dass die Wärmespeicherstangen 30 frei entlang ihrer Längsrichtung L thermisch expandieren können. Die Komponenten der Halterung 22 werden mit Bezug auf FIG. 2 näher erläutert.

Wie in FIG. 2 gezeigt, umfasst der Kassettenrahmen 20 an seiner Boden- oder Grundseite 21 ein Rahmenteil 24 und an der gegenüberliegenden Stirnseite ein weiteres Rahmenteil 24. Die beiden Rahmenteile 24 sind durch Seitenwände 26 verbunden, so dass der Kassettenrahmen 20 im Querschnitt geschlossen ist. Eine Vorder- und Rückseite sind hingegen vollständig offen, so dass ein Wärmetransferfluid durch den Kassettenrahmen 20 strömen kann.

Die beiden Rahmenteile 24 haben Aufnahmelöcher 24A für jeweils eine Wärmespeicherstange. Dadurch ragen beide Enden einer Wärmespeicherstange 30 in entsprechende Aufnahmelöcher 24A. Die Aufnahmelöcher 24A begrenzen in einer Ebene senkrecht zur Längsachse L den Raum für eine Wärmespeicherstange und halten dadurch die Wärmespeicherstange. Daher bilden Rahmenteile 24 mit ihren Aufnahmelöchern 24A einen Teil der Halterungen 22.

Die Halterungen 22 werden außerdem durch eine Führungsschiene 23 gebildet, welche sich zwischen den Seitenwänden 26 des Kassettenrahmens 20 erstreckt. Die Führungsschiene 23 umfasst Löcher 23A, welche in ihrer Anordnung den Aufnahmelöchern 24A von einem der Rahmenteile 24 entsprechen. Im zusammengebauten Zustand erstreckt sich jede Wärmespeicherstange 30 durch eines der Löcher 23A.

In Längsrichtung L begrenzen die Rahmenteile 24 einen Freiraum F für die Wärmespeicherstangen. Eine Länge oder Abmessung des Freiraums F soll hier inklusive des zusätzlichen Raums durch die Aufnahmelöcher 24A verstanden werden. Die Rahmenteile 24 gewährleisten eine sichere Position der Wärmespeicherstangen in Längsrichtung L. Dabei ist eine Länge des Freiraums F geringfügig größer als die Länge der Wärmespeicherstangen, damit eine thermische Expansion der Wärmespeicherstangen erfolgen kann, ohne dass ein Druck gegen den Kassettenrahmen 20 entstehen könnte.

Nach einem Zusammenbau einer Wärmespeicherkassette 20 wird diese möglicherweise für z.B. einen Transport in eine andere Orientierung gebracht. Daher ist ein sicherer Halt der Wärmespeicherstangen bzw. eine Begrenzung des Raums für die Wärmespeicherstangen in der Wärmespeicherkassette 20 in jeder Richtung wichtig.

Indem die Wärmespeicherstangen nicht an irgendeiner anderen Komponente starr befestigt sind, können die Wärmespeicherstangen (insbesondere in ihrer Längsrichtung) thermisch frei expandieren, ohne dass relevante Materialspannungen zu angrenzenden Komponenten drohen. Insbesondere sind die Wärmespeicherstangen nicht starr mit dem Kassettenrahmen 20 befestigt, sondern werden lediglich von diesem getragen und in einer bestimmten Position gehalten bzw. gestützt.

Hierfür ist die Gestaltung der Rahmenteile 24 relevant, wie am besten in FIG. 3 sichtbar. FIG. 3 zeigt im oberen Bereich das Rahmenteil 24 halbtransparent, so dass die in das Rahmenteil 24 hineinragenden Wärmespeicherstangen 30 sichtbar sind. Im mittleren Figurenbereich ist das Rahmenteil 24 in einer Schrägansicht gezeigt. Im unteren Figurenbereich ist ein Querschnitt gezeigt, in welchem das Hineinragen der Wärmespeicherstangen 30 in das Rahmenteil 24 sichtbar ist.

Das Rahmenteil 24 ist hohl und weist an einer Seite die Aufnahmelöcher 24A auf. Auf seiner gegenüberliegenden Seite, das heißt der Außenwand des Rahmenteils 24, sind hingegen keine Löcher vorhanden oder zumindest keine Löcher, die groß genug wären, um eine Wärmespeicherstange 30 hindurchzulassen.

Die Wärmespeicherstangen 30 und die Größe des Hohlraums im Rahmenteil 24 sind so dimensioniert, dass bei jeder Betriebstemperatur (bzw. bei jeder Temperatur innerhalb eines vorgegebenen Auslegungstemperaturbereichs) eine Lücke L1 zwischen den Wärmespeicherstangen 30 und der Innenseite 24B der Außenwand des Rahmenteils 24 verbleibt. Außerdem ist die Dimensionierung so gewählt, dass bei einer minimalen Betriebstemperatur (bzw. einer vorgegebenen minimalen Auslegungstemperatur) die Wärmespeicherstangen 30 noch in die Aufnahmelöcher 24A hineinragen. Dadurch wird gewährleistet, dass die Wärmespeicherstangen 30 bei jeder erwarteten Temperatur auch über die Aufnahmelöcher 24A des Rahmenteils 24 gestützt werden. Würden hingegen bei einem aufrecht stehenden System die Wärmespeicherstangen 30 bei niedriger Temperatur nicht in die Aufnahmelöcher 24A des Rahmenteils 24 hineinragen, würde ein Kippschutz lediglich durch die Führungsschiene(n) erreicht, was bei einer Verlagerung einer mehrere Meter langen Stahlstange um wenige Grad bereits zu einem möglicherweise problematisch hohen Momentaufbau / Kräften führen würde.

Der Kassettenrahmen 20 weist an seinen beiden Seitenwänden 26 nach außen hervorstehende Vorsprünge 25 auf. Durch diese Vorsprünge 25 kann der Kassettenrahmen 20 in einem Modul gehalten werden, was später näher beschrieben wird.

An einer oberen Seite / Außenseite des oberen Rahmenteils 24 sind zudem (mindestens) zwei Nocken oder Ösen 27 vorhanden, an welchen die Wärmespeicherkassette 10 von einem Kran oder einer anderen Maschine gehoben werden kann.

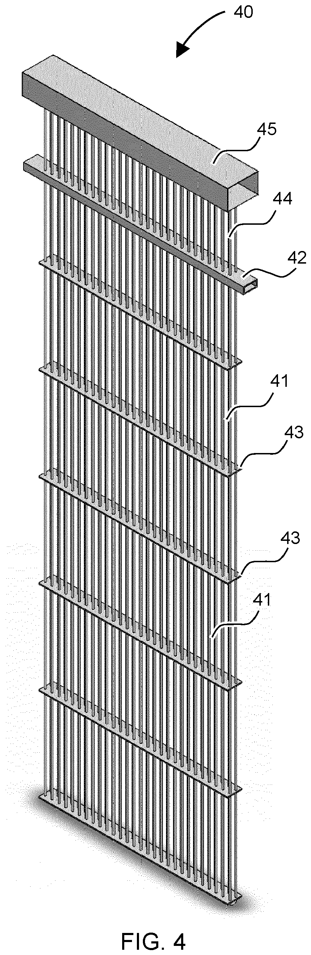

### FIG. 4: Elektrische Heizvorrichtung

FIG. 4 zeigt eine Perspektivdarstellung einer elektrischen Heizvorrichtung 40 eines Ausführungsbeispiels eines erfindungsgemäßen Wärmespeichers.

Die elektrische Heizvorrichtung 40 wandelt elektrische Energie in Wärme um. Hierzu umfasst die elektrische Heizvorrichtung 40 mehrere Heizdrähte bzw. allgemein elektrische Leitungen 41, welche aufgrund ihres elektrischen Widerstands bei einem Stromfluss Wärme produzieren. Die elektrischen Leitungen 41 verlaufen mäanderförmig über einen Bereich, welcher in seinen Abmessungen im Wesentlichen der Querschnittsfläche der Wärmespeicherkassette entspricht. Eine Hülle, ein Rahmen oder ein Gehäuse kann die elektrischen Leitungen 41 umgeben und eine elektrische Isolierung und/oder eine mechanische Strukturgebung der elektrischen Leitungen 41 bewirken. Die elektrischen Leitungen 41 werden außerdem durch mehrere Halteplatten 43 gehalten. Jede Halteplatte hat mehrere Öffnungen, z.B. mindestens 20 Öffnungen, durch welche die elektrischen Leitungen 41 verlaufen und gehalten werden.

Die elektrische Heizvorrichtung 40 umfasst außerdem eine seitlich hervorstehende Trägerstange 42. Die elektrischen Leitungen 41 verlaufen ausschließlich auf einer Seite der Trägerstange 42, in der dargestellten Orientierung unterhalb der Trägerstange 42. Mittels der Trägerstange 42 kann die elektrische Heizvorrichtung 40 in einem Wärmespeichermodul gehalten werden, wie später näher beschrieben wird. Auf der gegenüberliegenden Seite der Trägerstange 42, (in der dargestellten Orientierung oberhalb der Trägerstange,) sind elektrische Zuleitungen 44 vorhanden, welche mit den Leitungen 41 elektrisch verbunden sind. Die Zuleitungen 44 bilden eine Kühlstrecke, um entfernt positionierte Elektronik vor thermischen Schäden zu schützen. Die Zuleitungen 44 führen zu einer Anschlussbox 45, in welcher sich elektrische Anschlüsse befinden, zur Verbindung mit entfernt angeordneten elektronischen Komponenten, insbesondere einer SPS.

Die Anordnung der elektrischen Heizvorrichtung 40 sowie der Wärmespeicherkassetten in einem Wärmespeichermodul wird mit Bezug auf die folgenden Figuren erläutert. Die dargestellte Anzahl von Wärmespeicherkassetten eines Wärmespeichermoduls ist rein beispielhaft. Im Vergleich zum gezeigten Beispiel kann auch eine größere oder kleinere Anzahl an Wärmespeicherkassetten pro Wärmespeichermodul verwendet werden.

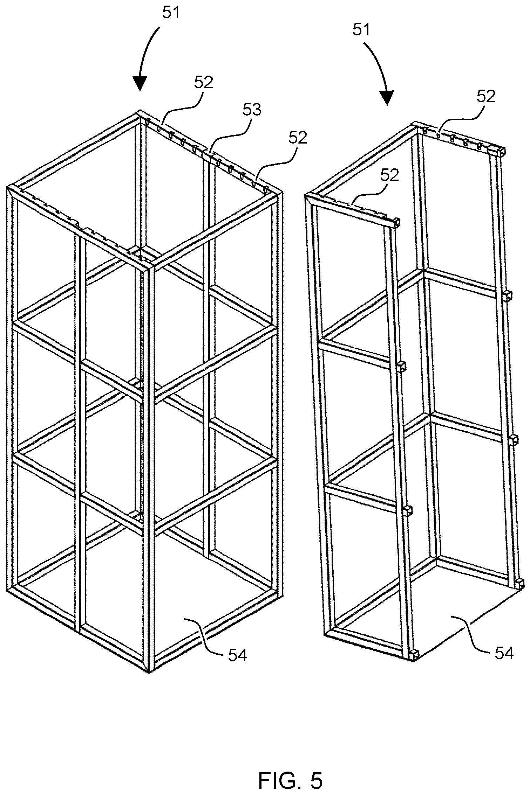

### FIG. 5 bis 7: Wärmespeichermodul

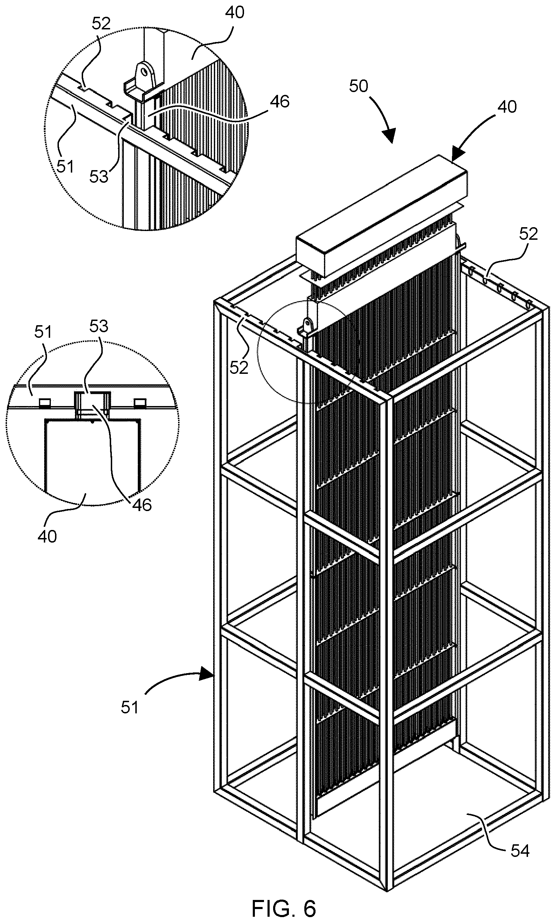

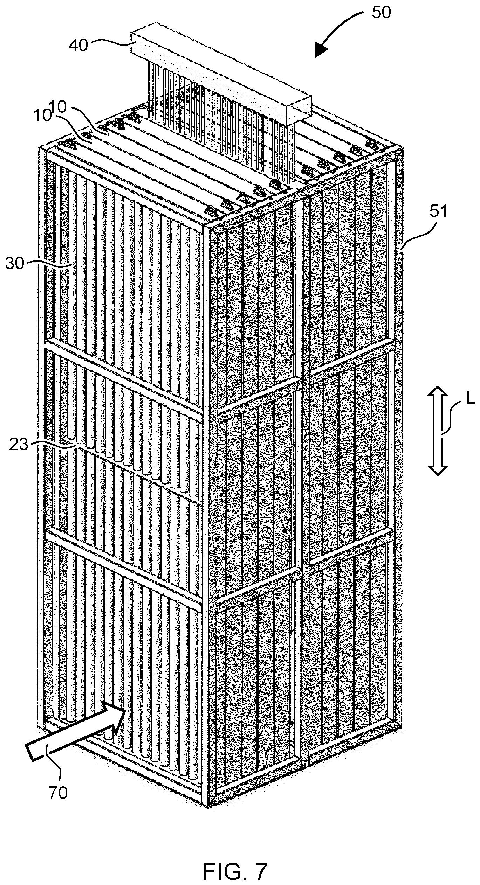

FIG. 5 zeigt im linken Bereich einen Modulrahmen 51 eines Wärmespeichermoduls. Mit dem Modulrahmen 51 werden eine elektrische Heizvorrichtung und Wärmespeicherkassetten gehalten. Im rechten Bereich zeigt FIG. 5 eine perspektivische Schnittansicht des Modulrahmens 51. FIG. 6 zeigt den Modulrahmen 51 mit einer darin aufgenommenen elektrischen Heizvorrichtung 40. FIG. 7 zeigt ein Wärmespeichermodul 50, umfassend den Modulrahmen 51, die darin aufgenommene elektrische Heizvorrichtung 40 und die gehaltenen Wärmespeicherkassetten 10.

Wie in FIG. 5 gezeigt, umfasst der Modulrahmen 51 mehrere Aufnahmenuten 52 zum Halten von Wärmespeicherkassetten und zwei Heizvorrichtung-Aufnahmenuten 53 zum Halten der elektrischen Heizvorrichtung. Im dargestellten Beispiel befinden sich die Aufnahmenuten 52 allein an oberen Rahmenteilen des Modulrahmens 51. Am Modulrahmen 51 können aber auch zusätzliche Seitenschienen oder Seitenwände mit Nuten vorhanden sein, welche sich über die Gesamtlänge der Wärmespeicherkassetten bzw. der Heizvorrichtung erstrecken (nicht dargestellt).

Der Modulrahmen 51 ist an seinem Boden mit einer Bodenplatte 54 verbunden, z.B. verschweißt. Die Abmessungen der Bodenplatte 54 entsprechen im Wesentlichen den Querschnittsabmessungen des Modulrahmens 51. Dadurch können mehrere Modulrahmen 51 mit jeweiliger Bodenplatte 54 eng nebeneinander aufgestellt werden. Zwischen benachbarten Modulrahmen 51 kann eine Lücke, die z.B. mindestens 2mm beträgt, gewährleisten, dass benachbarte Modulrahmen 51 auch unabhängig von ihren thermischen Expansionen nicht gegeneinander drücken und dadurch keinerlei (Material-) Spannungen aufeinander ausüben. Durch die Abstände der Module zueinander verbleibt auch die Möglichkeit, diese bei Bedarf separat über Fixierungen lokal zu positionieren. Außerdem können bestimmte Komponenten zwischen den Modulen verbaut werden, insbesondere Komponenten zur aktiven Steuerung des Strömungsprofils (z.B. Strömungsbrecher, Umlenkbleche, Diffusoren, Düsen).

FIG. 6 zeigt den Modulrahmen 51 mit eingesetzter elektrischer Heizvorrichtung 40. Die Heizvorrichtung 40 steht auf der Bodenplatte 54, welche das Gewicht der Heizvorrichtung 40 trägt. Die Heizvorrichtung 40 ist aber nicht an der Bodenplatte 54 befestigt. Die Gefahr eines Umkippens der Heizvorrichtung 40 wird ausgeschlossen, indem Vorsprünge 46 der Heizvorrichtung 40 in die Heizvorrichtung-Aufnahmenuten 53 hineinragen, siehe Detailansichten im linken Bereich der FIG. 6. Die elektrische Heizvorrichtung 40 wird somit am Modulrahmen 51 gehalten, ohne dass es eine starre Befestigung am Modulrahmen 51 gäbe. Dadurch werden mechanische Spannungen vermieden, welche durch eine thermische Expansion der Komponenten auftreten könnten. Außerdem können das Modul, bzw. die sich daran befindlichen Komponenten (Kassetten sowie Heizelemente) symmetrisch verbaut werden, wodurch der Schwerpunkt des modularen Systems stets mittig liegt und eine zusätzliche Stabilität gegen Umkippen erreicht wird. Alternativ ist auch eine ungerade Anzahl an Wärmespeicherkassetten 10 pro Wärmespeichermodul 50 möglich, wodurch innerhalb des Wärmespeichermoduls 50 unterschiedlich viele Wärmespeicherkassetten 10 vor und hinter der elektrischen Heizvorrichtung 40 angeordnet sind.

FIG. 7 zeigt, wie der Modulrahmen 51 außer der elektrischen Heizvorrichtung 40 auch mehrere Wärmespeicherkassetten 10 hält. Die Wärmespeicherkassetten 10 stehen ebenfalls auf der Bodenplatte 54 und werden vor einem Umkippen bewahrt, indem seitliche Vorsprünge 25 (in FIG. 1 gekennzeichnet) der Wärmespeicherkassetten 10 in die Aufnahmenuten 52 eingreifen. Die Wärmespeicherkassetten 10 sind nicht mit dem Modulrahmen 51, der Bodenplatte oder irgendeiner anderen Komponente starr verbunden, so dass auch hier mechanische Spannungen vermieden werden, welche durch eine thermische Expansion entstehen könnten.

Da das Gewicht der Wärmespeicherkassetten 10 und der Heizvorrichtung 40 von der Bodenplatte und nicht vom Modulrahmen 51 getragen wird, kann der Modulrahmen entsprechend einfacher ausgeführt sein.

Eine Strömungsrichtung 70 für ein Wärmetransferfluid ist in FIG. 7 mit einem Pfeil gekennzeichnet. Die Strömungsrichtung 70 verläuft senkrecht zu einer Fläche der Wärmespeicherkassetten 10 bzw. der elektrischen Heizvorrichtung 40, wobei die Fläche durch z.B. die Längsachse der Wärmespeicherstangen und der Richtung, in welcher die Wärmespeicherstangen in derselben Wärmespeicherkassette 10 aufgereiht sind, aufgespannt wird. Das Wärmetransferfluid strömt über die gesamte Fläche einer Wärmespeicherkassette 10 durch das Wärmespeichermodul 50.

Während dem Zusammenbau und/oder dem Betrieb des Wärmespeichers kann ein Wärmespeichermodul 50 aufrecht stehend angeordnet sein, wie in den FIG. 5-7 gezeigt. Andere Anordnungen werden mit Bezug auf die folgende Figur beschrieben.

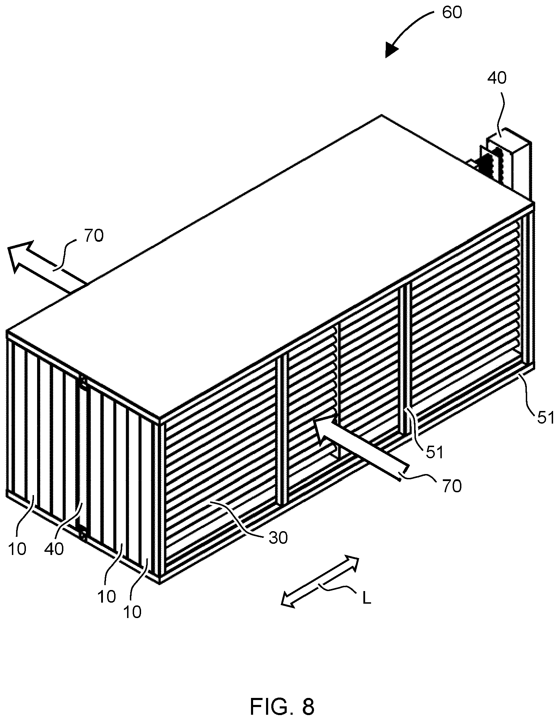

### FIG. 8: liegendes Wärmespeichermodul

FIG. 8 zeigt ein Wärmespeichermodul 60 in einer liegenden Anordnung. Das Wärmespeichermodul kann so aufgebaut sein, wie zu den vorherigen Figuren beschrieben. In der liegenden Anordnung erstreckt sich die Längsachse L der Wärmespeicherstangen horizontal. Das Wärmespeichermodul 60 steht hierbei nicht auf der zuvor beschriebenen Bodenplatte (welche in FIG. 8 nicht gezeigt ist oder auch an dieser Seite entfallen kann). Die Strömungsrichtung 70 verläuft weiterhin senkrecht zur Fläche der Wärmespeicherkassetten 10.

In der dargestellten liegenden Anordnung steht jede Wärmespeicherkassette 10 auf ihrer längsten Seitenwand, so dass die von einer Wärmespeicherkassette 10 gehaltenen Wärmespeicherstangen 30 übereinander sind. Eine andere liegende Anordnung ist durch Drehung um 90° möglich, so dass die Wärmespeicherstangen 30 einer Wärmespeicherkassette 10 in derselben Horizontalebene liegen. Die Wärmespeicherkassetten 10 sind dann im Modulrahmen 51 übereinander gestapelt.

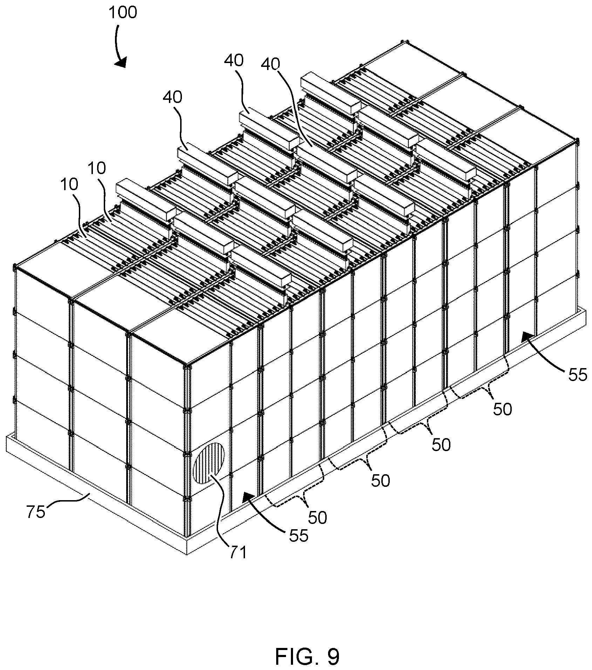

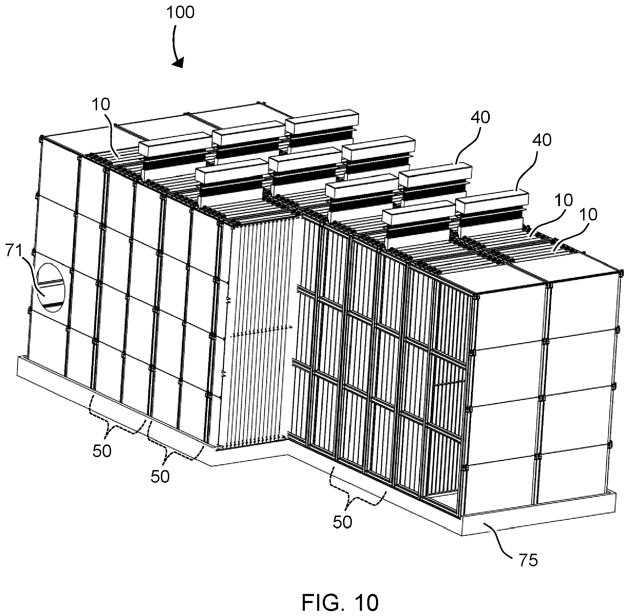

### FIG. 9 und 10: Wärmespeicher mit stehenden Wärmespeichermodulen

Die FIG. 9 und 10 zeigen ein Ausführungsbeispiel eines erfindungsgemäßen Wärmespeichers 100. FIG. 9 zeigt eine Perspektivdarstellung, während FIG. 10 eine perspektivische Schnittansicht zeigt. Der Wärmespeicher 100 umfasst mehrere Wärmespeichermodule 50, welche auf ihrer Bodenplatte stehend angeordnet sind. Mehrere Wärmespeichermodule 50 stehen hintereinander in einer Reihe, so dass ein Wärmetransferfluid die Wärmespeichermodule 50 einer Reihe nacheinander durchströmt. Im dargestellten Beispiel sind drei solcher Reihen gezeigt. Die Reihen können parallel durchströmt werden, so dass das Wärmetransferfluid auf die verschiedenen Reihen aufgeteilt wird; alternativ können die Reihen auch durch entsprechende Umlenkwände seriell miteinander verbunden werden, so dass das Wärmetransferfluid nacheinander die Reihen durchströmt. Die Anzahl an Reihen und die Anzahl an Wärmespeichermodulen 50 pro Reihe kann variabel gewählt werden, je nach geplanter Kapazität des Wärmespeichers 100. Außer den bisher beschriebenen Wärmespeichermodulen 50 mit elektrischer Heizvorrichtung 40 können auch Wärmespeichermodule 55 ohne elektrische Heizvorrichtung 40 verwendet werden. Diese Wärmespeichermodule 55 werden am Anfang und Ende jeder Reihe an Wärmespeichermodulen angeordnet. Dadurch wird weniger Wärmeenergie von den elektrischen Heizvorrichtungen 40 an Rändern des Wärmespeichers 100 verloren. Zudem werden hierdurch Schnittstellen zu übrigen Komponenten des Anlagensystems (z.B. zu- und abführende Rohrleitungen zur Zirkulation des Wärmetransferfluids zu dem Wärmeübertrager) geringeren thermischen Spannungen ausgesetzt, da ihre Distanz zu den heißesten Komponenten im Anlagensystem (den Heizelementen), erhöht ist. Die Wärmespeichermodule 55 können so aufgebaut sein wie zu den Wärmespeichermodulen 50 beschrieben, außer dass keine elektrische Heizvorrichtung 40 und optional keine Aufnahmenuten am Modulrahmen für eine elektrische Heizvorrichtung 40 vorhanden sind. Die Wärmespeichermodule 55 können im Vergleich zu den Wärmespeichermodulen 50 kleiner gestaltet sein, insbesondere durch eine geringere Anzahl an Wärmespeicherkassetten 10. Symmetrische Beziehungen können hierbei beibehalten werden.

Bei eingeschalteten elektrischen Heizvorrichtungen 40 im Zuge der Ladung (Aufheizung) erfährt das Wärmetransferfluid mehrmals abwechselnd eine Wärmeaufnahme an einer der elektrischen Heizvorrichtungen 40 und eine Wärmeabgabe an den darauffolgenden Wärmespeicherkassetten 10. Im Fall der Entladung des Wärmespeichers durchströmt das Wärmetransferfluid den Wärmespeicher, nimmt von den heißen Wärmespeicherkassetten 10 und Heizelementen Wärme auf und gibt diese dann an den Bedarfsträger/ Verbraucher ab. Die Heizelemente können während der Entladung allgemein ein- oder ausgeschaltet sein. Bei ausgeschalteten Heizelementen kann deren Temperatur ähnlich der Temperatur der Wärmespeicherstangen 30 sein, weshalb beim Entladen auch von den Heizelementen Wärme auf das Wärmetransferfluid übertragen wird.

Der Wärmespeicher 100 kann eine isolierende Außenwand umfassen, welche die äußeren Wärmespeichermodule nach außen begrenzt. In der Außenwand kann eine Einlassöffnung 71 für das Wärmetransferfluid vorhanden sein sowie eine hier nicht dargestellte Auslassöffnung. Die Auslassöffnung kann das Wärmetransferfluid zu einem Wärmetauscher oder Verdampfer führen und anschließend wieder zur Einlassöffnung 71. Es können Ventilatoren, Pumpen oder andere Beförderungsmittel für das Wärmetransfluid vorhanden sein, welche insbesondere in dem Abschnitt von der Auslassöffnung bis zur Einlassöffnung 71 angeordnet sein können, so dass sie nicht der Hitze ausgesetzt sind, die an den Wärmespeichermodulen 50 vorherrscht.

Die Wärmespeichermodule 50 stehen auf Trägerblöcken 75, welche mit einer Isolierung versehen sein können und auf einem Fundament stehen können. Bei dem Fundament kann es sich beispielsweise um ein Beton-, CMS-Faser-, Mineralfaser- oder keramisches Fundament handeln.

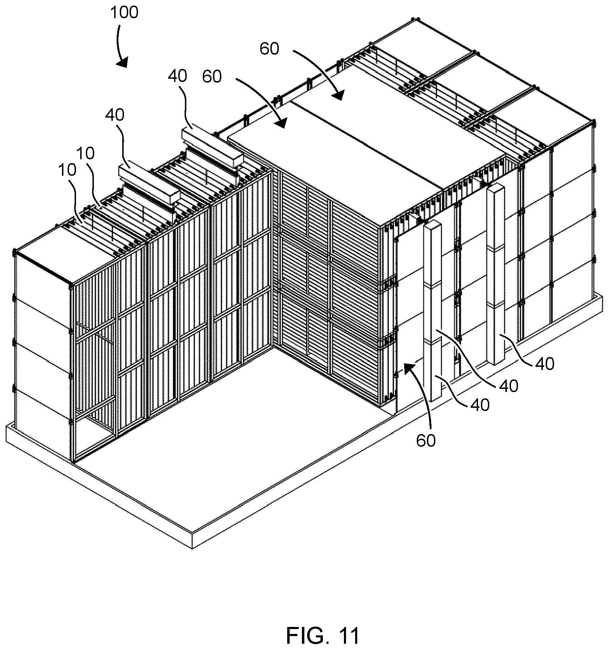

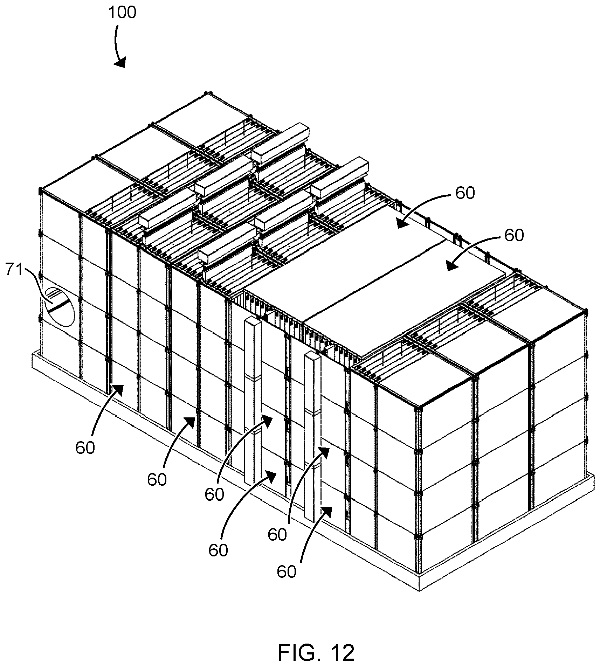

### FIG. 11 und 12: Wärmespeicher mit teils liegenden Wärmespeichermodulen

Die FIG. 11 und 12 zeigen ein weiteres Ausführungsbeispiel eines erfindungsgemäßen Wärmespeichers 100. FIG. 11 zeigt eine perspektivische Schnittansicht, während FIG. 12 eine Perspektivdarstellung zeigt. Während im vorherigen Ausführungsbeispiel alle Wärmespeichermodule stehend angeordnet sind, sind hier nur einige Wärmespeichermodule 50 stehend angeordnet, während andere Wärmespeichermodule 60 liegend angeordnet sind. Es können jeweils mehrere liegende Wärmespeichermodule 60 übereinander gestapelt sein, wodurch eine Stapelhöhe gerade der Höhe eines aufrecht stehenden Wärmespeichers 50 gleicht. Bei einer Stapelung können die Wärmespeichermodule 60 direkt aufeinander liegen oder über ein (hier nicht dargestelltes) Gestell getragen sein, so dass ein unteres Wärmespeichermodul 60 nicht das Gewicht der darüber gestapelten Wärmespeichermodule 60 tragen muss.

Eine durchmischte Anordnung stehender und liegender Wärmespeichermodule 50, 60 kann die Strömung das Wärmetransferfluids beeinflussen und gegebenenfalls für eine gleichmäßigere Temperaturverteilung im Wärmespeicher sowie eine erhöhte thermische Leistungsübertragung infolge der Erhöhung der Turbulenz des Wärmetransferfluids sorgen.

Die zu den verschiedenen Figuren beschriebenen Varianten können miteinander kombiniert werden. Die beschriebenen Ausführungsbeispiele sind rein illustrativ und Abwandlungen hiervon sind im Rahmen der beigefügten Ansprüche möglich.

### Bezugszeichenliste

- 10: Wärmespeicherkassette
- 20: Kassettenrahmen
- 21: Kassettenrahmenboden
- 22: Halterungen zum Halten der Wärmespeicherstangen 30
- 23: Führungsschiene zum Halten der Wärmespeicherstangen 30
- 23A: Loch der Führungsschiene
- 24: Rahmenteil
- 24A: Aufnahmeloch am Rahmenteil für eine Wärmespeicherstange
- 24B: Innenseite der Außenwand des Rahmenteils 24
- 25: Vorsprung am Kassettenrahmen / Randabschnitt des Kassettenrahmens
- 26: Seitenwände des Kassettenrahmens
- 27: Nocken zum Heben der Wärmespeicherkassette
- 30: Wärmespeicherstangen
- 40: elektrische Heizvorrichtung
- 41: elektrische Leitungen
- 42: Trägerstange
- 43: Halteplatten für die elektrischen Leitungen 41
- 44: Zuleitungen der elektrischen Heizvorrichtung
- 45: Steuerbox
- 46: Vorsprung / Randabschnitt der Heizvorrichtung 40
- 50: (stehendes) Wärmespeichermodul
- 51: Modulrahmen
- 52: Aufnahmenut des Modulrahmens zum Halten einer Wärmespeicherkassette
- 53: Aufnahmenut des Modulrahmens zum Halten einer elektrischen Heizvorrichtung
- 54: Bodenplatte eines Wärmespeichermoduls
- 55: Wärmespeichermodul 55 ohne elektrische Heizvorrichtung
- 60: liegendes Wärmespeichermodul
- 70: Strömungsrichtung eines Wärmetransferfluids
- 71: Einlassöffnung für Wärmetransferfluid
- 75: Trägerblöcke
- 100: Wärmespeicher
- F: Freiraum
- L: Längsrichtung der Wärmespeicherstangen
- L1: Lücke

## Patentansprüche

1. Ein Wärmespeicher zum Speichern elektrischer Energie in Form von Wärmeenergie, umfassend:
mindestens eine elektrische Heizvorrichtung (40) zum Umwandeln von elektrischer Energie in Wärmeenergie;
**gekennzeichnet durch**
mehrere Wärmespeicherkassetten (10), wobei jede Wärmespeicherkassette (10) einen Kassettenrahmen (20) und mehrere im Kassettenrahmen (20) gehaltene Wärmespeicherstangen (30) umfasst,
wobei jede Wärmespeicherkassette (10) Halterungen (22) zum Halten der Wärmespeicherstangen (30) in einer vorgegebenen Position umfasst, und wobei mindestens ein Ende (31) jeder Wärmespeicherstange (30) unfixiert ist, so dass innerhalb des Kassettenrahmens (20) eine freie thermische Expansion der Wärmespeicherstangen (30) in Längsrichtung (L) der Wärmespeicherstangen (30) ermöglicht ist.

2. Der Wärmespeicher nach Anspruch 1,
wobei in einem fertig montierten Zustand der Wärmespeicherkassetten (10) jeder Kassettenrahmen (20) in Längsrichtung (L) der gehaltenen Wärmespeicherstangen (30) geschlossen ist, so dass die Wärmespeicherstangen (30) nicht in Längsrichtung (L) aus dem Kassettenrahmen (20) austreten können, und
wobei ein von einem der Kassettenrahmen (20) umrahmter Freiraum (F) in Längsrichtung (L) der gehaltenen Wärmespeicherstangen (30) größer ist als eine Länge der Wärmespeicherstangen (30), um die freie thermische Expansion der Wärmespeicherstangen (30) in Längsrichtung (L) zu ermöglichen,
wobei sich im Fall, dass der Kassettenrahmen (20) Aufnahmelöcher (24A) für die Wärmespeicherstangen (30) aufweist, der Freiraum (F) bis in die Aufnahmelöcher (24A) hinein erstreckt, während sich im Fall, dass der Kassettenrahmen (20) keine Aufnahmelöcher (24A) für die Wärmespeicherstangen (30) aufweist, der Freiraum (F) zwischen gegenüberliegenden Teilen des Kassettenrahmens (20) erstreckt.

3. Der Wärmespeicher nach Anspruch 2,
wobei der Freiraum (F) und die Länge der Wärmespeicherstangen (30) so gewählt sind, dass in Längsrichtung (L) eine Lücke (L1) verbleibt, welche größer ist als eine thermische Expansionslänge der Wärmespeicherstangen (30) bei Erhitzen der Wärmespeicherstangen (30) über einen Auslegungstemperaturbereich des Wärmespeichers.

4. Der Wärmespeicher nach einem der Ansprüche 1 bis 3,
wobei die Halterungen (22) von einem der Kassettenrahmen (20) mindestens eine Führungsschiene (23) umfassen, und
wobei sich jede Führungsschiene (23) senkrecht zur Längsrichtung (L) der Wärmespeicherstangen (30) erstreckt und mehrere Löcher (23A) aufweist, wobei sich durch jedes Loch (23A) eine der Wärmespeicherstangen (30) erstreckt.

5. Der Wärmespeicher nach einem der Ansprüche 1 bis 4,
wobei jeder Kassettenrahmen (20) eine Grundseite und eine gegenüberliegende Stirnseite hat, und
wobei der Kassettenrahmen (20) an der Grundseite und/oder der Stirnseite ein Rahmenteil (24) mit Aufnahmelöchern (24A) oder Aufnahmevertiefungen als Stützung der Wärmespeicherstangen (30) umfasst, wobei das Rahmenteil (24) mit Aufnahmelöchern (24A) oder Aufnahmevertiefungen einen Teil der Halterungen (22) bildet.

6. Der Wärmespeicher nach einem der Ansprüche 1 bis 5, weiterhin umfassend:
mehrere Wärmespeichermodule (50, 60), wobei jedes Wärmespeichermodul (50, 60) einen Modulrahmen (51) aufweist, welcher dazu eingerichtet ist, mehrere der Wärmespeicherkassetten (10) und mindestens eine elektrische Heizvorrichtung (40) ohne Fixierung zu halten.

7. Der Wärmespeicher nach Anspruch 6,
wobei der Modulrahmen (51) an zwei gegenüberliegenden Seiten jeweils mehrere Aufnahmenuten (52) für einen jeweiligen Vorsprung einer der Wärmespeicherkassetten (10) aufweist, so dass jede Wärmespeicherkassette (10) in zwei gegenüberliegenden Aufnahmenuten (52) gehalten wird.

8. Der Wärmespeicher nach Anspruch 6 oder 7,
wobei der Modulrahmen (51) zum Halten der elektrischen Heizvorrichtung (40) an zwei gegenüberliegenden Seiten jeweils mindestens eine Heizvorrichtung-Aufnahmenut (53) für einen jeweiligen Randabschnitt (46) der elektrischen Heizvorrichtung (40) aufweist.

9. Der Wärmespeicher nach einem der Ansprüche 6 bis 8,
wobei zumindest einige der Wärmespeichermodule (50) mit einer Lücke, welche thermische Expansionen ermöglicht, aneinander angeordnet sind, so dass sie von durchströmendem Wärmetransferfluid nacheinander durchströmt werden, und ihre Modulrahmen (51) nicht starr zueinander fixiert sind.

10. Der Wärmespeicher nach einem der Ansprüche 1 bis 9,
wobei die Wärmespeicherkassetten (10) aufrecht angeordnet sind, so dass die Längsrichtung (L) der Wärmespeicherstangen (30) vertikal ausgerichtet ist, wobei die Wärmespeicherstangen (30) auf einem Kassettenrahmenboden (21) stehen, so dass sie in vertikaler Richtung frei thermisch expandieren können, wobei die Halterungen (22) einen Kippschutz für die Wärmespeicherstangen (30) bilden.

11. Der Wärmespeicher nach einem der Ansprüche 6 bis 10,
wobei die Wärmespeicherkassetten (10) von einem der Wärmespeichermodule (50) auf einer Bodenplatte (54) dieses Wärmespeichermoduls (50) stehen, wobei die Bodenplatte (54) das Gewicht der Wärmespeicherkassetten (10) trägt, wobei ein Umkippen der Wärmespeicherkassetten (10) durch Aufnahmenuten (52) an Seiten des Wärmespeichermoduls (50) und in die Aufnahmenuten (52) hineinragende Randabschnitte (25) der Wärmespeicherkassetten (10) verhindert wird.

12. Der Wärmespeicher nach einem der Ansprüche 6 bis 11,
wobei mindestens eines der Wärmespeichermodule (60) liegend angeordnet ist, so dass die Längsrichtung (L) der Wärmespeicherstangen (30) horizontal ausgerichtet ist, wobei die Halterungen (22) das Gewicht der Wärmespeicherstangen (30) tragen und jede Wärmespeicherstange (30) an mindestens zwei Stellen stützen, ohne Fixierung der Wärmespeicherstange (30), um die freie thermische Expansion der Wärmespeicherstangen (30) in Längsrichtung (L) zu gewährleisten.

13. Verfahren zur Herstellung eines Wärmespeichers zum Speichern elektrischer Energie in Form von Wärmeenergie, umfassend:
Bereitstellen mindestens einer elektrischen Heizvorrichtung (40) zum Umwandeln von elektrischer Energie in Wärmeenergie;
Bilden mehrerer Wärmespeicherkassetten (10) jeweils ausgehend von einem Kassettenrahmen (20), welcher im Querschnitt an drei Seiten geschlossen und an einer vierten Seite geöffnet ist, wobei an dem Kassettenrahmen (20) Halterungen (22) zum Halten von Wärmespeicherstangen (30) in einer vorgegebenen Position vorhanden sind; wobei in jeden Kassettenrahmen (20) mehrere Wärmespeicherstangen (30) an der offenen vierten Seite eingeführt werden, so dass die Wärmespeicherstangen (30) durch die Halterungen (22) in Position gehalten werden; wobei anschließend jeder Kassettenrahmen (20) an der vierten Seite geschlossen wird, wobei mindestens ein Ende jeder Wärmespeicherstange (30) unfixiert ist, so dass innerhalb des Kassettenrahmens (20) eine freie thermische Expansion der Wärmespeicherstangen (30) in Längsrichtung (L) der Wärmespeicherstangen (30) ermöglicht ist.
